**Europäisches Patentamt**

**European Patent Office**

**Office européen des brevets**

(19)

(11) Numéro de publication: **0 053 963 B1**

# FASCICULE DE BREVET EUROPEEN

(12)

(45) Date de publication du fascicule du brevet:
**10.04.85**

(21) Numéro de dépôt: **81401843.8**

(22) Date de dépôt: **20.11.81**

(51) Int. Cl.⁴: **G 01 S 7/32**, G 01 S 13/78, H 03 K 5/08

(54) Dispositif de quantification de signaux en impulsions pour radar secondaire.

(30) Priorité: **09.12.80 FR 8026072**

(43) Date de publication de la demande:
**16.06.82 Bulletin 82/24**

(45) Mention de la délivrance du brevet:
**10.04.85 Bulletin 85/15**

(84) Etats contractants désignés:
**DE GB IT NL SE**

(56) Documents cités:
**FR - A - 2 214 896**

**THE REVIEW OF SCIENTIFIC INSTRUMENTS, vol. 43, no. 11, novembre 1972, NEW YORK (US), F.E. HOGE et al.** *"A slope reversal video processor having amplitude and pulse width discrimination"*, **pages 1612-1618**

(73) Titulaire: **THOMSON-CSF, 173, Boulevard Haussmann, F-75379 Paris Cedex 08 (FR)**

(72) Inventeur: **Devolder, Claude, THOMSON-CSF SCPI 173, bld Haussmann, F-75360 Paris Cedex 08 (FR)**
Inventeur: **Gaultier, Gérard, THOMSON-CSF SCPI 173, bld Haussmann, F-75360 Paris Cedex 08 (FR)**

(74) Mandataire: **Benoit, Monique et al, THOMSON-CSF SCPI 173, Bld Haussmann, F-75379 Paris Cedex 08 (FR)**

## Description

L'invention se rapporte aux systèmes radar de surveillance de l'espace aérien comprenant un radar primaire et un radar secondaire; elle concerne, plus précisément, un dispositif électronique permettant, à la sortie du récepteur du radar secondaire, la quantification de signaux en impulsions qui constituent les réponses transmises par les avions sous surveillance.

Dans un système radar de surveillance de l'espace aérien, le radar secondaire, d'une part, interroge les avions en vol équipés d'un répondeur coopératif et, d'autre part, capte en retour les réponses transmises par ces avions. Les fondements des radars secondaires et les Conventions internationales s'y rapportant sont donnés, notamment, dans l'ouvrage de M.I. Skolnik «Radar Handbook», Chapitre 38, (Mc Graw-Hill, 1971).

Le signal de réponse, ou plus brièvement la réponse générée par les répondeurs de radar secondaire, est un train d'impulsions toutes identiques comprenant un nombre N d'impulsions qui forment un code numérique; ces impulsions de code sont parenthésées par deux impulsions d'encadrement qui permettent de reconnaître les réponses et d'identifier le début et la fin du mot de code. Les réponses transmises par les différents avions sont spécifiques de chaque appareil et fournissent des informations complémentaires et/ou redondantes de celles données par les échos du radar primaire. Ces réponses sont captées, au sol, par l'antenne du radar secondaire, puis amplifiées et démodulées par le récepteur. Antérieurement aux opérations d'exploitation de ces réponses, les signaux en impulsions de sortie du récepteur doivent être remis en forme, c'est-à-dire séparés des signaux parasites puis quantifiés en niveau.

L'opération de quantification des signaux de sortie du récepteur soulève plusieurs difficultés, résultant notamment: des réponses asynchrones issues de répondeurs interrogés par des radars secondaires adjacents; de la large dynamique d'amplitude des réponses liée aux paramètres de gain de la liaison air-sol; de la superposition tout au moins partielle des réponses issues d'avions groupés; des interférences électromagnétiques parasites et du bruit propre au récepteur.

Le problème qui se pose est de réaliser un dispositif de quantification dont le seuil de quantification soit asservi à l'amplitude instantanée des signaux et dont la position des flancs des signaux de sortie est, en présence des signaux multiples, faiblement erronée. Plus brièvement, la fonction du dispositif de quantification est de restituer aussi précisément que possible la forme des impulsions de chacune des réponses transmises par les avions interrogés.

Des dispositifs de quantification ont déjà été réalisés, ils comprennent essentiellement: un comparateur de niveau comportant une première entrée, ou entrée d'un signal, reliée à la sortie vidéofréquence du récepteur et une seconde entrée, ou entrée de référence, reliée à une source de tension continue, fixe ou variable, et généralement asservie au niveau du bruit thermique du récepteur. Ces dispositifs de quantification de l'art antérieur présentent plusieus inconvénients: la durée des signaux quantifiés dépend de l'amplitude absolue des signaux d'entrée, il en résulte que la position des flancs des impulsions est erronée. Un réglage satisfaisant du niveau de référence ne peut jamais être réalisé, un niveau trop haut conduit à une perte de sensibilité en limite de portée; inversement, un niveau trop bas introduit un élargissement des impulsions des réponses dans le cas de réponse de forte amplitude.

D'autre part, dans la technique des discriminateurs de temps on connaît un processeur vidéo qui est décrit dans la revue «The Review of Scientific Instruments» vol 43 N° 11 Nov. 1972 pages 1612-1618. Ce processeur vidéo permet d'élaborer un signal de sortie représentatif de l'instant précis d'arrivée d'un signal d'impulsion de durée connue, et ceci, indépendamment du niveau d'amplitude de ce signal. Ce processeur vidéo comprend essentiellement un comparateur de niveau dont les entrées sont connectées à deux voies de signal ayant une entrée commune et des gains identiques. L'une de ces voies inclut une ligne à retard dont la durée est égale à la durée d'impulsion et l'entrée commune de ces voies de signal est connectée au signal d'impulsion par l'intermédiaire d'un filtre vidéo adapté à la durée d'impulsion. L'inversion de pente au point de chevauchement dans le temps des signaux d'entrée du comparateur de niveau est détectée pour fournir le signal de mesure de l'instant d'arrivée du signal. Un inconvénient de ce processeur vidéo est qu'il ne fournit pas une mesure précise des positions des flancs montant et descendant de l'impulsion.

Le but de l'invention est de remédier aux inconvénients précités des dispositifs de mesure des positions des flancs des signaux d'impulsions.

Pour atteindre ce but un dispositif permettant de quantifier des signaux d'impulsions comprend un comparateur de nveau dont les entrées sont connectées à une première et une seconde voie de signal ayant une entrée commune, dans lesquelles voies de signal la différence de niveau continu fixe le seuil de sensibilité du dispositif; la première voie de signal comporte un premier circuit de retard dont la durée totale de retard est sensiblement égale à la somme du temps de montée et de descente des impulsions; et ce circuit de retard est muni de prises intermédiaires sensiblement équidistantes qui sont connectés respectivement aux entrées d'un opératuer du type «OU», la sortie duquel représente l'amplitude maximale simultanément présente sur les prises intermédiaires est connectée à l'entrée correspondante du comparateur de niveau et, la seconde voie de signal comporte essentiellement un second circuit de retard dont la durée de retard est sensiblement égale au temps de montée des impulsions.

D'autres caractéristiques et avantages fournis par l'invention apparaîtront dans la description détaillée d'un mode de réalisation d'un dispositif de quantification, faite en regard des dessins annexés; sur ces dessins:

la fig. 1 représente la forme des impulsions transmises par les répondeurs coopérant avec les radars secondaires,

la fig. 2 représente un mode de réalisation d'un dispositif de quantification selon l'invention,

les fig. 3a, 3b et 3c représentent la forme des principaux signaux associés au dispositif de quantification représenté à la fig. 2,

la fig. 4 représente une variante de réalisation du dispositif de quantification de la fig. 2.

La réponse transmise par les répondeurs coopérant avec les radars secondaires est un train d'impulsions défini par quinze fentes de temps dont la durée nominale a été fixée à 1,45 µs; à l'intérieur de ces fentes de temps sont positionnées quatorze impulsions, toutes identiques en durée et en amplitude, la durée nominale de ces impulsions ayant été fixée à 0,45 µs, la fente de temps centrale étant normalement toujours inoccupée. Le rang de ces impulsions est internationalement identifié par les lettres majuscules indexées $F_1$, $C_1$ à $D_4$ et $F_2$; les impulsions $F_1$ et $F_2$ positionnées respectivement dans la première et la quinzième fente de temps assurent le parenthésage des douze impulsions de code $C_1$ à $D_4$. De la combinaison de la présence ou de l'absence des impulsions de code, 4096 réponses différentes peuvent être formées. Eventuellement, une seizième fente de temps, distante de 4,35 µs de l'impulsion $F_2$ est affectée à la transmission d'une impulsion particulière, l'impulsion «SPI».

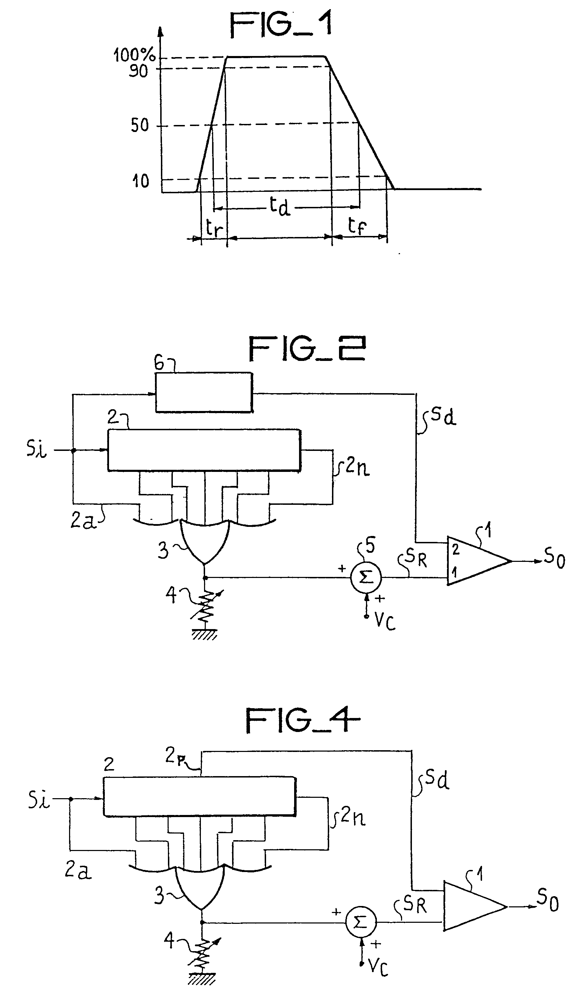

La fig. 1 représente la forme trapézoïdale des impulsions formant la réponse transmise par le répondeur. La durée nominale ($t_d$) de ces impulsions, définie au niveau 50% du palier, est de 0,45 µs; les durées maximales de montée ($t_r$) et de descente ($t_f$) des flancs de ces impulsions, définies entre les niveaux 10 et 90% sont respectivement de 0,1 et 0,2 µs. En l'absence de distorsion dans la chaîne de transmission et de signaux parasites, les signaux de réponse peuvent être facilement reconnus, puis décodés.

La forme des réponses fournies par le récepteur de radar secondaire est notablement différente de celles transmises par le répondeur, d'une part, du fait de la présence des multiples signaux d'interférence déjà énumérés dans le préambule de la description et, d'autre part, des caractéristiques d'amplification de la chaîne de réception, notamment, en raison de la largeur de bande des circuits d'amplification, la durée des impulsions étant légèrement accrue et les caractéristiques non linéaires des différents circuits introduisant des déformations des flancs des impulsions.

La fig. 2 représente, sous la forme d'un schéma synoptique, un mode de réalisation d'un dispositif de quantification de signaux en impulsions, conforme à l'invention. Le signal d'entrée ($S_i$) étant formé d'impulsions à vidéofréquence superposées à des signaux de bruit et à des signaux d'interférence. Ce dispositif de quantification comprend les éléments suivants:

une première et une seconde voies de formation de signaux ayant une entrée commune reliée au signal d'entrée ($S_i$) et des sorties reliées respectivement aux entrées d'un comparateur de niveau (1) à deux états de sortie ($S_o$), un premier état au niveau bas et un second état au niveau haut.

La première voie de formation de signaux comprend un premier circuit de retard (2) muni d'une pluralité de prises ($2_a$ à $2_n$) sensiblement équidistantes, ces prises étant reliées respectivement à un opérateur (3) du type «OU», la sortie de cet opérateur comportant un réglage de gain (4) et étant reliée à une première entrée d'un circuit de sommation (5) dont la seconde entrée est reliée à une source de tension ($V_c$) continue, fixe ou variable, la sortie de ce circuit de sommation étant reliée à une première entrée du comparateur de niveau (1).

La seconde voie de formation de signaux comprend essentiellement un second circuit de retard (6) relié à une seconde entrée du comparateur de niveau (1).

Le comparateur de niveau (1) est un amplificateur différentiel à gain élevé dont la vitesse de réponse est compatible avec la largeur de bande des signaux en impulsions; il peut, avantageusement, être réalisé selon une technologie intégrée. Les premier et second circuits de retard (2 et 6) sont des lignes à retard analogiques dont la largeur de bande est égale ou supérieure à la largeur de bande du signal d'entrée ($S_i$). La durée de retard du premier circuit de retard (2) est sensiblement égale à la durée de montée et de descente des impulsions d'entrée, la durée de retard du second circuit de retard (6) est sensiblement égale à la durée de montée des impulsions d'entrée. Le nombre de prises du premier circuit de retard est proportionnelle à la largeur de bande effective du signal d'entrée ($S_i$). L'opérateur du type «OU» peut être constitué par l'association de composants actifs unidirectionnels tels que des diodes.

La fonction de la première voie de formation de signaux est de générer une pluralité de répliques du signal d'entrée progressivement décalées dans le temps et de fournir un signal de sortie dont la valeur instantanée représente l'amplitude maximale des répliques simultanément présentes sur les prises du circuit de retard.

La fonction de la seconde voie de formation de signaux est de fournir une réplique du signal d'entrée décalée d'une durée sensiblement égale à la durée de montée des impulsions d'entrée et dépendant du niveau de quantification choisi, ce niveau de quantification étant défini comme une fraction du niveau maximal, ou de palier, des impulsions d'entrée.

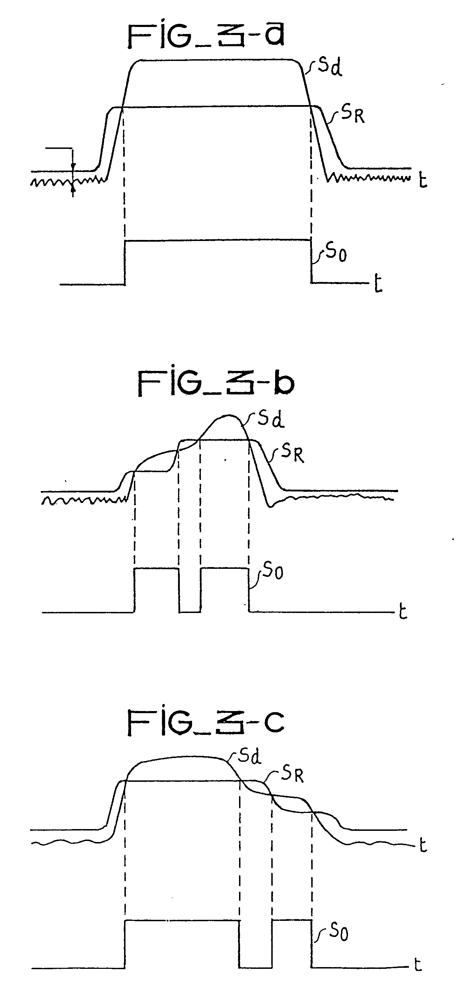

On décrira maintenant le fonctionnement du dispositif de quantification, en regard des fig. 3a, 3b et 3c, qui représente la forme des signaux aux entrées et à la sortie du comparateur de niveau.

La fig. 3a se rapporte au cas d'une impulsion isolée superposée à un faible niveau de bruit thermique; le signal ($S_R$) constitue un signal de référence de l'amplitude de l'impulsion d'entrée ($S_i$) et sa durée est supérieure à celle de l'impulsion d'entrée corresondante d'une quantité égale à la durée de retard du second circuit de retard, ce signal ($S_R$) est superposé à la tension ($V_c$) qui fixe le seuil de sensibilité du dispositif; le signal ($S_d$) est une réplique du signal d'entrée ($S_i$) décalée dans le temps d'une quantité déterminée par le retard du second circuit de retard (6). Le niveau de quantification du dispositif est fixé par le rapport des amplitudes des paliers du signal ($S_R$) et du signal ($S_d$), ce niveau de quantification peut être modifié par le réglage de l'élément potentiométrique (4) disposé dans la première voie de formation de signaux.

Les fig. 3b et 3c se rapportent aux cas d'impulsions d'amplitudes inégales qui se chevauchent dans le temps. Sur ces figures, on remarque que le niveau de quantification ($S_R$) se règle sur le niveau et en avance du signal ($S_d$), ce qui permet de séparer des impulsions qui se chevauchent à l'entrée, comme l'indique le signal de sortie ($S_o$).

La fig. 4 représente, sous la forme d'un schéma synoptique, une variante de réalisation du dispositif de quantification décrit à la fig. 2. Selon cette variante de réalisation, les deux voies de formation de signaux sont combinées au niveau du premier circuit de retard (2); à cet effet, on munit un premier circuit de retard d'une prise supplémentaire ($2_p$) correspondant au retard de temps du second circuit de retard et l'on relie directement cette prise supplémentaire à la seconde entrée du comparateur de niveau (1). Il est aussi possible, dans le but de limiter le nombre des prises, d'utiliser la prise intermédiaire dont le retard de temps est sensiblement égal à celui de la prise supplémentaire. Lorsque les durées de montée et de descente des signaux en impulsions sont sensiblement égales, la prise supplémentaire est placée au milieu du circuit de retard.

Le dispositif de quantification de signaux en impulsions, décrit aux fig. 2 et 4, peut être disposé à la sortie vidéofréquence du récepteur d'un radar secondaire installé au sol, cette sortie vidéo comportant un moyen de restitution de la composante continue des signaux de sortie. A la sortie de ce dispositif de quantification peut être disposé un discriminateur de largeur d'impulsions qui éliminera les impulsions du signal quantifié ($S_o$) dont la durée sera inférieure à 0,3 µs environ. La source de tension ($V_c$) peut être asservie au niveau du bruit thermique du récepteur et/ou à la distance radar des réponses. La durée de retard du premier circuit de retard (2) peut être de l'ordre de 0,2 à 0,3 µs, et le nombre de prises ($2_a$ à $2_n$) incluant les prises d'entrée et de sortie peut être compris entre 6 et 8. La durée de retard du second circuit de retard (6) peut être égale sensiblement à la moitié de la durée de retard du premier circuit de retard. Comme représenté à la fig. 4, le premier circuit de retard peut être combiné avec le second circuit de retard.

Ce dispositif de quantification constitue un système autoadaptatif, le niveau de quantification étant constamment asservi à l'amplitude instantanée des signaux en impulsions délivrés par le récepteur; cette caractéristique fournit plusieurs avantages: la sensibilité de détection du radar secondaire est accrue avec, par voie de conséquence; un nombre de réponses supérieur par largeur de faisceau d'antenne, en comparaison avec les dispositifs de quantification de l'art antérieur, l'erreur sur la position des flancs des impulsions est réduite et les réponses superposées de niveaux différents peuvent être séparées dans certaines limites.

De par sa nature analogique, le dispositif de quantification se prête particulièrement à des réalisations mettant en œuvre des composants analogiques, toutefois les circuits de retard, notamment, peuvent être réalisés selon des techniques numériques utilisant, de préférence, des registres à décalage à transfert de charge incrémentés par un signal d'horloge dont la fréquence est de l'ordre de grandeur de la largeur de bande du signal d'entrée ($S_i$).

Les modes de réalisation du dispositif de quantification selon l'invention ont été décrits à titre illustratif, mais non limitatif, notamment, le moyen de réglage des gains des première et seconde voies de formation de signaux peut être incorporé dans l'une ou l'autre de ces voies et la source de tension ($V_c$) peut être superposée à l'une de ces deux voies en prenant la précaution d'inverser la polarité de cette source.

Le dispositif de quantification de signaux trouve son application dans les systèmes de transmission des données numériques et, notamment, dans la chaîne de transmission des signaux de réponse des répondeurs captés par les radars secondaires installés au sol.

**Revendications**

1. Dispositif permettant de quantifier des signaux d'impulsions, indépendamment de leur niveau d'amplitude, caractérisé en ce qu'il comprend un comparateur de niveau (1) dont les entrées sont connectées à une première et une seconde voie de signal ayant une entrée commune, dans lesquelles voies la différence de niveau continu fixe le seuil de sensibilité du dispositif; la première voie de signal comporte un premier circuit de retard (2) dont la durée totale de retard est sensiblement égale à la somme du temps de montée ($t_r$) et de descente ($t_f$) des flancs des impulsions et ayant une pluralité de prises intermédiaires ($2_a$ à $2_n$) qui sont connectées respectivement aux entrées d'un opérateur du type «OU» (3), la sortie duquel, représentant l'amplitude maximale simultanément présente sur les prises intermédiaires ($2_a$ à $2_n$), est connectée à l'entrée correspondante du comparateur de niveau (1), et, la seconde voie de signal comporte essentiellement un circuit de retard (6) dont la durée de retard est sensiblement égale au temps de montée (t$_r$) des impulsions.

2. Dispositif selon la revendication 1, caractérisé en ce que la différence de niveau continu entre les première et seconde voies de signal est fournie par un circuit de sommation (5) disposé entre la sortie de l'opérateur du type «OU» (3) et l'entrée correspondante de comparateur de niveau (1), l'autre entrée du circuit de sommation étant connectée à une source de tension continue (V$_e$).

3. Dispositif selon la revendication 2, caractérisé en ce que la source de tension continue (V$_c$) connectée au circuit de sommation (5) a une valeur fixe prédéterminée.

4. Dispositif selon la revendication 2, caractérisé en ce que la source de tension continue (V$_c$) connectée au circuit de sommation (5) est variable en fonction du temps.

5. Dispositif selon la revendication 1, caractérisé en ce que le circuit de retard de la seconde voie de formation des signaux est constitué par une fraction du circuit de retard (2) de la première voie de formation des signaux.

6. Dispositif selon la revendication 1, caractérisé en ce que les premier et second circuits de retard (2, 6) sont des registres à décalage du type à transfert de charge incrémentés par un signal d'horloge dont la fréquence est de l'ordre de la largeur de bande des signaux d'entrée en impulsions.

7. Radar secondaire comprenant une station sol et des répondeurs coopératifs disposés à bord des avions; cette station sol incluant un récepteur qui fournit en vidéofréquence les signaux de réponse transmis par les répondeurs, caractérisé en ce qu'il comprend connecté à la sortie de ce récepteur, un dispositif de quantification selon l'une des revendications 1 à 6 et un circuit de commande de la source de tension continue (V$_c$) qui est connecté au circuit de sommation (5).

**Patentansprüche**

1. Quantifizierunsvorrichtung für Impulssignale unabhängig von ihrem Amplitudenpegel, dadurch gekennzeichent, dass sie einen Pegelkomparator (1) aufweist, dessen Eingänge an einen ersten und einen zweiten Signalweg, die einen gemeinsamen Eingang besitzen, angeschlossen sind, wobei der Unterschied der Gleichspannungspegel in diesen Wegen die Empfindlichkeitsschwelle der Vorrichtung festlegt und der erste Signalweg einen ersten Verzögerungsschaltkreis (2) aufweist, dessen Gesamtverzögerungsdauer im wesentlichen der Summe der Anstiegszeit (t$_r$) und der Abfallzeit (t$_f$) der Impulsflanken gleich und der eine Vielzahl von Zwischenabgriffen (2$_a$ – 2$_n$) besitzt, die je an Eingänge eines Operators vom Type «ODER» (3) angeschlossen sind, wobei dessen Ausgang der der grössten jeweils an den Zwischenabgriffen auftretenden Amplitude entspricht, an den entsprechenden Eingang des Pegelkomparators (1) angeschlossen ist, wogegen der zweite Signalweg im wesentlichen einen Verzögerungskreis (6) enthält, dessen Verzögerungsdauer im wesentlichen der Anstiegszeit (t$_r$) der Impulse gleicht.

2. Vorrichtung nach Anspruch 1, dadurch gekennzeichnet, dass der Unterschied der Gleichspannungspegel an den beiden Signalwegen von einem Summierkreis (5) geliefert wird, der zwischen den Ausgang des Operators vom Typ «ODER» (3) und dem entsprechenden Eingang des Pegelkomparators (1) liegt, während der andere Eingang des Summierkreises an einer Gleichspannungsquelle (V$_c$) liegt.

3. Vorrichtung nach Anspruch 2, dadurch gekennzeichnet, dass die Gleichspannungsquelle (V$_c$), die an den Summierkreis (5) angeschlossen ist, einen vorbestimmten Festwert besitzt.

4. Vorrichtung nach Anspruch 2, dadurch gekennzeichnet, dass die Gleichspannungsquelle (V$_c$), die an den Summierkreis (5) angeschlossen ist, abhängig von der Zeit variabel ist.

5. Vorrichtung nach Anspruch 1, dadurch gekennzeichnet, dass der Verzögerungskreis des zweiten Signalbildungswegs durch einen Bruchteil des Verzögerungskreises (2) des ersten Signalbildungswegs gebildet wird.

6. Vorrichtung nach Anspruch 1, dadurch gekennzeichnet, dass die beiden Verzögerungskreise (2,6) Schieberegister vom Ladungstransfertyp sind, die von einem Taktsignal weitergeschaltet werden, dessen Frequenz in der Grössenordnung der Bandbreite der Eingangssignalimpulse liegt.

7. Sekundärradar mit einer Bodenstation und kooperativen Antwortgebern, die sich an Bord von Flugzeugen befinden, wobei diese Bodenstation einen Empfänger enthält, der in Videofrequenz die von den Antwortgebern übertragenen Antwortsignale liefert, dadurch gekennzeichnet, dass an den Ausgang dieses Empfängers eine Quantifiziervorrichtung nach einem der Ansprüche 1 bis 6 und eine Steuervorrichtung für die an den Summierkreis (5) angeschlossene Gleichspannungsquelle (V$_c$) angeschlossen sind.

**Claims**

1. A device for quantifying pulse signals independently of their amplitude level, characterized in that it comprises a level comparator (1), the inputs of which are connected to a first and a second signal channel having a common input, the difference of DC level in these channels defining the sensitivity of the device, the first signal channel comprising a first delay circuit (2) whose total delay duration is substantially equal to the sum of the rise time (t$_r$) and the fall time (t$_f$) of the pulse slopes, and which presents a plurality of intermediate pick-offs (2$_a$–2$_n$) connected respectively to the inputs of an operator of the «OR»-type (3), the output of this operator, representing the highest amplitude which is simultaneously present at the intermediate pick-offs (2$_a$–2$_n$) is connected to the corresponding input of the level comparator (1), whereas the second signal channel comprises substantially a delay circuit (6) whose delay duration is substantially equal to the rise time ($t_r$) of the pulses.

2. A device according to claim 1, characterized in that the DC level difference between the first and the second signal channel is furnished by a summing circuit (5) disposed between the output of the «OR»-type operator (3) and the corresponding input of the level comparator (1), whereas the other input of the summing circuit is connected to a DC voltage source ($V_c$).

3. A device according to claim 2, characterized in that the DC voltage source ($V_c$) connected to the summing circuit (5) has a predetermined fixed value.

4. A device according to claim 2, characterized in that the DC voltage source ($V_c$) connected to the summing circuit (5) is variable with time.

5. A device according to claim 1, characterized in that the delay circuit of the second signal channel is constituted by a fraction of the delay circuit (2) of the first signal-forming channel.

6. A device according to claim 1, characterized in that the two delay circuits (2, 6) are shift registers of the charge transfer type which are incremented by a clock signal the frequency of which corresponds approximately to the band width of the input signal pulses.

7. A secondary radar comprising a ground station and airborne cooperative reply devices, the ground station including a receiver which furnishes in the video frequency band the reply signals transmitted by the reply device, characterized in that it comprises, connected to the output of that receiver, a quantification device according to one of the claims 1 to 6 as well as a circuit for controlling the DC voltage source ($V_c$) connected to the summing circuit (5).

# FIG_1

# FIG_2

# FIG_4

7

FIG_3-a

$S_d$

$S_R$

$t$

$S_0$

$t$

FIG_3-b

$S_d$

$S_R$

$S_0$

$t$

FIG_3-c

$S_d$

$S_R$

$t$

$S_0$

$t$